# EUROPEAN PATENT APPLICATION

(11) **EP 4 575 644 A1**
(43) Date of publication of application: **25.06.2025**
(21) Application number: 23218202.2
(22) Date of filing: 19.12.2023
(51) Int. Cl.: G03F 7/20

(54) **VESSEL CONFIGURED TO RECEIVE A RADIATION BEAM WITH A COLD TRAP FOR CONTAMINATION CAPTURE**

(71) Applicant: ASML Netherlands B.V., 5500 AH Veldhoven (NL)
(72) Inventor: REININK, Johan, 5500 AH Veldhoven (NL); DE VRIES, Gosse, Charles, 5500 AH Veldhoven (NL); VAN DER POST, Sietse, Thijmen, 5500 AH Veldhoven (NL); VAN DE KERKHOF, Marcus, Adrianus, 5500 AH Veldhoven (NL); PUTH, Alexander, Detlef, Franziskus, 5500 AH Veldhoven (NL); TUMER, Can, 5500 AH Veldhoven (NL); STORM, Arnoldus, Jan, 5500 AH Veldhoven (NL); OSORIO OLIVEROS, Edgar, Alberto, 5500 AH Veldhoven (NL); BRUSSAARD, Gerrit, Jacobus, Hendrik, 5500 AH Veldhoven (NL)
(74) Representative: ASML Netherlands B.V.

(57) **Abstract**

An assembly comprising a vessel configured to receive a radiation beam. The assembly comprises an internal structure forming part of the vessel or enclosed within the vessel, and a temperature control system configured to control a temperature of the internal structure to be in a range of 77 K to 140 K.

## Description

### FIELD

The present invention relates to methods and assemblies comprising a vessel with an internal structure configured to be cooled for contaminant removal. Specifically, it may relate to assemblies provided inside lithographic or metrology apparatuses for contaminant removal.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating/target medium, thereby generating an emitted radiation, optionally a high harmonic generation (HHG) comprising high frequency radiation.

Lithographic patterning exposures and measurements are often performed in a vacuum. One of the factors that may affect the lifetime of components inside these vacuums is the presence of contaminants, such as hydrocarbons and water. The short wavelengths of radiation used in lithography may crack hydrocarbons, which may result in carbon deposits on surfaces inside the apparatus. These deposits may occur especially in areas where high intensity radiation is present/incident. Water molecules present inside the vacuum chamber may also be fracked by short-wavelength radiation, and may cause deterioration of optical surfaces, for example through oxidation. Deposits of contaminants on elements such as optical elements guiding radiation may strongly reduce the performance of these elements. For example they may lead to a reduction in reflectivity, wavefront errors, etc.

Despite having strong vacuum pump systems, a vacuum chamber may also have some background partial pressure of contaminants, such as hydrocarbons and water. Keeping the surfaces inside a vessel such as optics free of contaminant deposition, e.g. through carbon deposition or oxidation, may therefore require extra measures. Keeping surfaces clean in a vacuum may be achieved for example by introducing a purge gas. A flow of clean gas may be directed and shaped such that contaminants may be swept away from the optics. Furthermore, some purge gases may create a cleaning environment by etching or a reducing environment which slows down oxidation.

If a surface of an optic is contaminated, its performance is reduced, and it may need to be cleaned. This cleaning may typically be performed ex-situ. This may require an optic swap, and associated downtime of the apparatus. In-situ cleaning, such as for example using a specifically chosen plasma, may sometimes be performed. However, not all contaminant depositions are cleanable, such as for example silicon-based deposits.

### SUMMARY

According to an aspect of the current disclosure there is provided an assembly comprising a vessel configured to receive a radiation beam. The assembly further comprises an internal structure forming part of the vessel or enclosed within the vessel, and a temperature control system configured to control a temperature of the internal structure to be in a range of 77 K to 140 K.

Optionally, the vessel may be configured to be at a pressure of 0.05 mbar or less during operation of the assembly, or 0.01 mbar or less.

Optionally, the temperature control system may be configured to control the temperature of the internal structure to be in a range from 90 K - 140 K, in a range from 90 K - 130 K, in a range from 100 K - 125 K, substantially 100 K.

Optionally, the radiation beam may comprise one or more wavelengths in a range of 1 nm - 20 nm, or 1 nm - 10 nm, or 10 nm - 20 nm, or 9 nm - 18 nm, or 13.5 nm.

Optionally, the internal structure may be configured to capture contaminants on at least one surface of the internal structure.

Optionally, the internal structure may be configured to remove captured contaminants from the vessel.

Optionally, the contaminants may comprise hydrocarbons.

Optionally, the contaminants may comprise water.

Optionally, the assembly may further comprise an optical component inside the vessel.

Optionally, the optical component may comprise a reflective optical component, and wherein directing the radiation beam by the optical component may comprise reflecting the radiation beam.

Optionally, the optical component may be configured to direct radiation having one or more wavelengths in a range of 1 nm to 20 nm.

Optionally, the internal structure may be configured to be cooled during a process of pumping down the pressure inside the vessel.

Optionally, the internal structure may comprise a texturized surface.

Optionally, the texturized surface may comprise at least one of nanoparticles or a metal aerogel.

Optionally, the internal structure may be enclosed within the vessel, and may be moveable inside the vessel.

Optionally, the internal structure may be moveable in and out of the vessel.

Optionally, the movable internal structure may be configured to be inserted in a propagation path of the radiation during pumping down of the vessel when the radiation beam is turned off, and is configured to be retracted from the propagation path before the radiation beam is turned on.

Optionally, the internal structure may comprise a plurality of insertable rods.

Optionally, the internal structure may comprise an extendable body for increasing the surface area of the internal structure.

Optionally, the internal structure may form part of the vessel, and forms part of an inner wall of the vessel.

Optionally, the temperature control system may comprise a motor for powering a cooling, and wherein the motor is separated from the vessel by a mechanical decoupler.

Optionally, the mechanical decoupler may be a heat exchanger.

Optionally, the motor may be configured to drive a compressor pump.

Optionally, the internal structure may be an enclosure enclosing an inner space. The closure my comprise an input end configured to be positioned in a propagation path of a radiation beam such that the radiation beam is directed into the inner space of the enclosure, and an output end configured to be positioned in the propagation path of the radiation beam such that the radiation beam is directed out of the inner space of the enclosure.

Optionally, the input end may comprise an elongated structure comprising a hollow core arranged along the propagation path of the radiation beam such that the radiation beam propagates along the hollow core of the elongated structure.

Optionally, the output end may comprise an elongated structure comprising a hollow core arranged along the propagation path of the radiation beam such that the radiation beam propagates along the hollow core of the elongated structure.

Optionally, the enclosure may be configured to capture contaminants on at least one surface adjacent the inner space so as to remove them from the inner space.

Optionally, the temperature control system may comprise a liquid nitrogen cooling system.

According to another aspect of the present disclosure there is provided a metrology apparatus comprising an assembly as set out above.

According to another aspect of the present disclosure there is provided an inspection apparatus comprising an assembly as set out above.

According to another aspect of the present disclosure there is provided an exposure apparatus comprising an assembly as set out above.

According to another aspect of the present disclosure there is provided aa lithographic apparatus comprising an assembly as set out above.

According to another aspect of the present disclosure there is provided a litho cell comprising an apparatus as set out above.

### BRIEF DESCRIPTION OF THE DRAWINGS

Embodiments will now be described, by way of example only, with reference to the accompanying schematic drawings, in which:
- Figure 1(a) depicts a schematic overview of a lithographic apparatus;
- Figure 1(b) depicts a schematic overview of a lithographic system;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts a schematic representation of an assembly for cryo-cooling inside a vessel;
- Figure 9 depicts a graphic representation of an assembly for cry-cooling using an enclosure; and
- Figure 10 depicts a graph of gas vapour pressure as a function of temperature for different types of gases.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

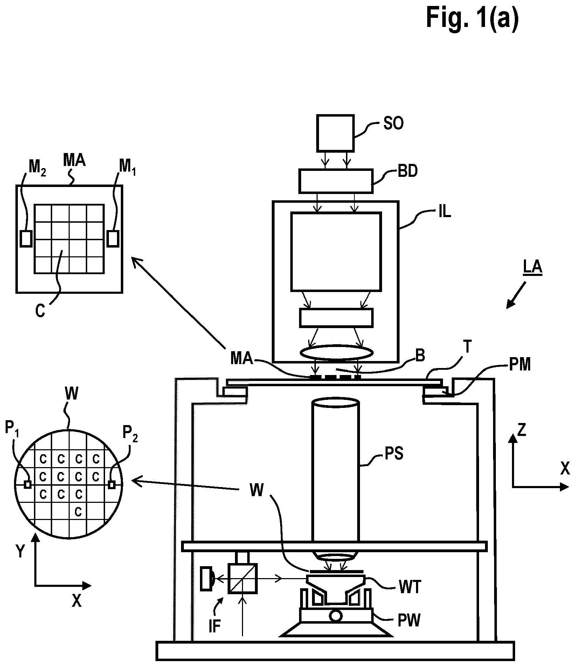

Figure 1(a) schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1(a)) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

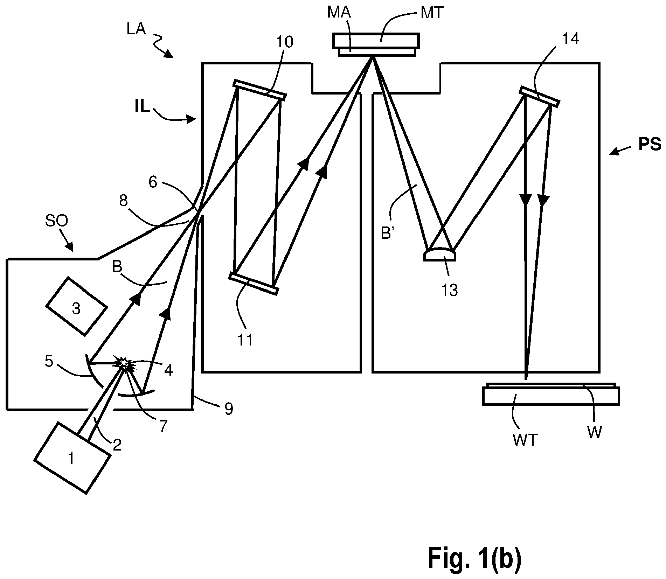

Figure 1(b) shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO2 laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

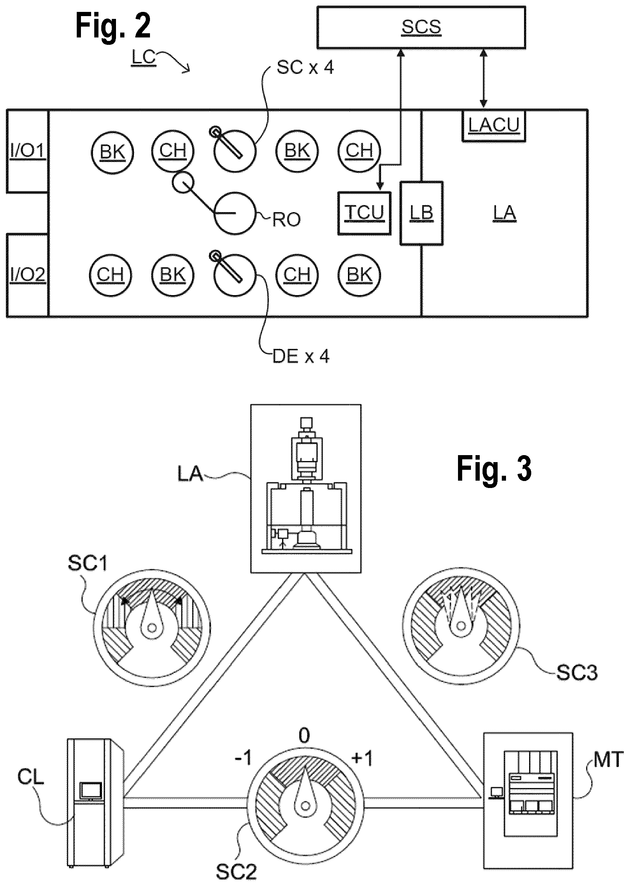

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

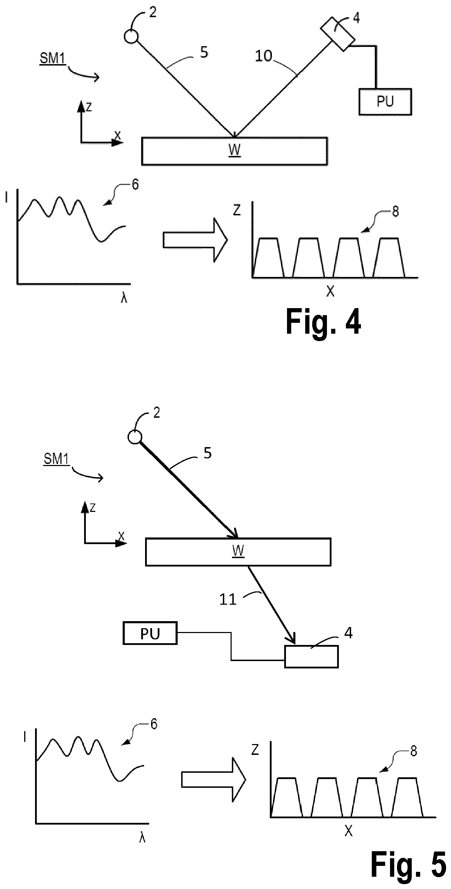

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

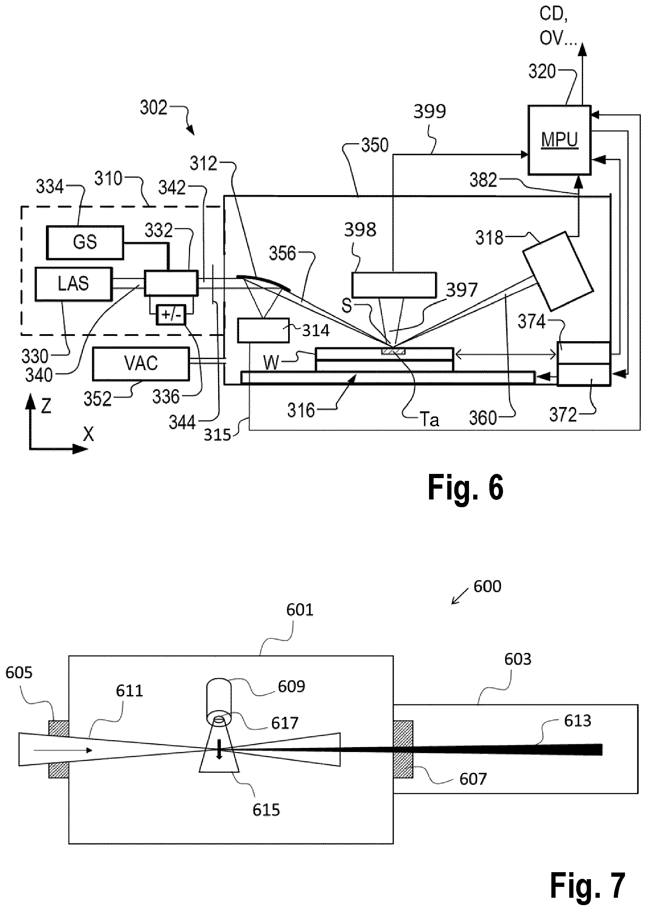

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source, as well as other types of sources, may have a gas target and be a gas jet/nozzle source, a capillary/fiber source or a gas cell source. The HHG source, as well as other types of sources, may have a solid or liquid target. Although HHG source with gas target is described in the text below, it will be appreciated that the invention is not limited to HHG source with gas target and may be used in HHG source with solid or liquid target and other types of source with any target. The gas target, solid target and liquid target may be referred as generating/target medium.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use HHG or any other types of sources mentioned above to obtain radiation at the desired wavelength(s).

Figure 7 shows a simplified schematic drawing of an embodiment 600 of an illumination source 310, which may be the illumination source for HHG. One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

Lithographic apparatus and associated metrology apparatus and inspection apparatus perform their patterning and/or measurement tasks in vacuum conditions. Even under vacuum conditions, non-negligible amounts of contaminants may be present inside the chamber where patterning/measurement takes place. This chamber may be referred to as a vessel. Contaminants may deposit on surfaces of components inside the vessel, especially in areas where high intensities of radiation are present. High intensity radiation, and in particular high intensities of short wavelength radiation may interact with contaminants such as hydrocarbons and/or water, and cause them to deposit on surfaces of optical components. This may significantly affect the performance of these components, and/or reduce their lifetime.

An existing technology for keeping components such as optical components clean, is to use a purge gas. However, purge gases may require a significant gas flow, which may be expensive and may put a large load on the vacuum pumps. As a result, such setups may require bigger and more expensive vacuum pumps. A workaround is to place the optical components to be kept clean inside a flushbox. A flushbox may be an enclosure with narrow input and output channels. Significant gas density and flow may be created in these channels. Using such a flush box may reduce gas consumption by one or more orders of magnitude.

Using a well-designed flushbox, the partial pressure of contaminants such as hydrocarbons inside the flush box may be several orders of magnitude smaller than in the vacuum vessel as a whole. However, it is difficult to design a flushbox around all components, for example due to lack of space, and/or because an optical component may need to be actuated. Actuators may be sources of contaminants, and should not be placed in a flushbox, while the optical component moved by the actuator should be located in the flush box. Other challenges with flushboxes may include that they make it more difficult to replace components contained within them, something that may be needed for servicing. Flushboxes may also add further complexity to an already complex setup.

Another challenge associated with using a purge gas, may be that some of the best known purge gases for self-cleaning (e.g. hydrogen) may add additional system complexity and material requirements to the whole system. This may be required to prevent unwanted etching of surfaces inside the vessel by the purge gas. Hydrogen may be too reactive, and elements such as silicon, tin, zinc, magnesium, etc. may be at risk of causing etching and/or oxidation. If this occurs, these elements may form additional contaminants inside the vessel. Purge gases may also be less than pure, and may contain contaminants themselves, such as water. The purge gas itself therefore may introduce additional contaminants inside the flushbox, which may reduce the lifetime of the optical components. Cleaning of mirrors may be difficult, and an impactful process. As a result of these challenges, prevention of contamination of surfaces inside a vessel is preferable over cleaning the surfaces.

Presented herein is an alternative to purge gases such as hydrogen, by using cryogenics. Cryogenics may be used to freeze out hydrocarbons, water, and/or other contaminants at low temperatures, so that they cannot escape. All hydrocarbons that exhibit long residence times on a surface at the operating temperature of the apparatus/vessel may be considered contaminants to be removed. This may be because these hydrocarbons may dissociate when exposed to short wavelength radiation, and may leave a carbon deposit on the surface of the optical component on which they are located. Lighter hydrocarbons (e.g. methane, ethane, and in some instances also propane, butane, or generally a hydrocarbon with a mass below 60 Dalton) may be more volatile and therefore less likely to have long residence times on a surface of an optical component. As a result, they may be more easily removed using a turbo vacuum system, and less likely to form a carbon deposit on a surface. The operating temperature of the vessel may be substantially room temperature, e.g. in a range from 5 degrees Celsius to 30 degrees Celsius.

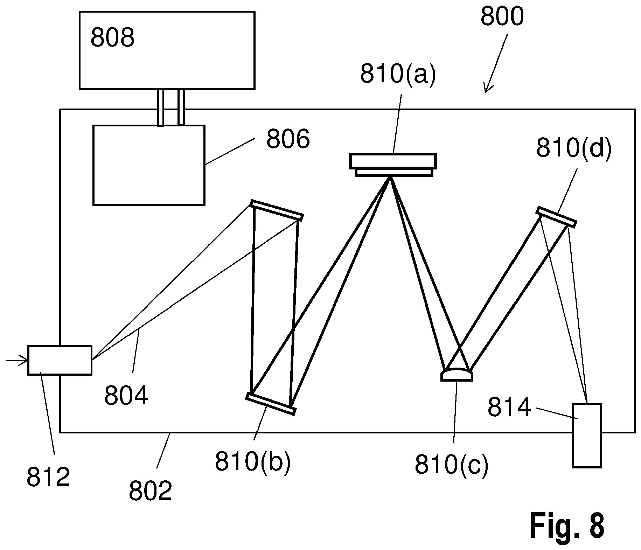

Figure 8 depicts a schematic representation of an assembly 800 which may be provided in a lithographic apparatus and/or a metrology apparatus. The assembly comprises a vessel 802 configured to receive a radiation beam 804. The assembly 800 further comprises an internal structure 806, wherein the internal structure may form part of the vessel or may be enclosed within the vessel. The assembly 800 further comprises a temperature control system 808 configured to control the temperature of the internal structure 806 to be in a range of 77 K to 140 K. The cooled surface(s) of the internal structure may be referred to as (a) cryo-surface(s). The assembly 800 may further comprise one or more optical components 810(a), 810(b), 810(c), 810(d) configure to direct radiation inside vessel 802. The vessel may be placed under vacuum during operation of the assembly. The assembly 800 may further comprise a radiation input 812 and radiation output 814, for providing radiation into the vessel 802 and out of the vessel 802, respectively. The optical components 810(a)-(d) depicted in figure 8 are provided as an example only, and other configurations of components may be provided.

An advantage of the assembly 800 as depicted in figure 8 may be that it can provide cryo-cooling inside a vessel in which high intensity radiation may be present and interacting with optical components. Having a cold surface present inside the vessel means that contaminants may be adsorbed onto the surface. The colder the surface, the harder it may be for adsorbed contaminants to escape. The cooled internal structure may replace a purging gas flow, without bringing any of the challenges and difficulties associated with the gas flow. The internal structure may be configured to capture contaminants on at least one surface of the internal structure so as to remove them vessel. The contaminants may comprise hydrocarbons, and/or water.

The low temperature may exponentially increase the residence time of a contaminant on the cold surface. This may be understood according to an Arrhenius law: τ = τ₀ exp(Eₐ /(kT)). In this equation τ may be the residence time, τ₀ (~ 10⁻¹³ s) may be the attempt to escape frequency, Eₐ may be the binding energy, T may be temperature, and k may be the Boltzmann constant. At sufficiently low temperatures, adsorbed species may virtually no longer leave the surface. Alternatively the vapour pressure of a contaminant at a low temperature may become so low that the source of contamination freezes out, and does not enter the vacuum any more. For example, at 77 K water may have a vapour pressure of < 10⁻¹² mbar, at which point all hydrocarbons may be solid, and only the lightest hydrocarbon (methane CH₄) may have some remaining vapour pressure.

One or more optical components 810(a), 810(b), 810(c), 810(d) may be present inside the vessel. The one or more optical components inside the vessel may be configured to interact with (e.g. guide or direct) radiation having one or more wavelengths in a range of 1 nm to 20 nm. Radiation may be incident on the components, making them vulnerable to contaminant the position, due to the localised presence of the shortwave radiation. The optical component may for example comprise of reflective optical component. Directing the radiation beam by the optical component may comprise reflecting or diffracting the radiation beam. The optical component may in some instances comprise transmissive optical component. The optical component may for example comprise a (toroidal) mirror, a filter, a grating, etc. The optical component may receive radiation that entered the vessel at an input end, and may direct at least a portion of the radiation towards and output end of the vessel.

The radiation that may propagate through the vessel may comprise short wavelength radiation. The radiation beam may comprise a plurality of wavelengths. The radiation beam may comprise for example one or more wavelengths in a range of 1 nm - 20 nm, or 1 nm - 10 nm, or 10 nm - 20 nm, or 9 nm - 18 nm. The radiation may for example comprise a wavelength of (approximately) 13.5 nm. This short wavelength radiation may be present at high intensities in localised areas. Due to the high energy associated with short wavelength radiation, their effects on particles such as contaminants present in the vacuum and/or at the surface of optical components such as mirrors may be significant. Therefore, contaminant removal may be of particular importance in setups using short wavelength radiation.

The temperature of the internal structure may be in a range of 77 K to 140 K. In some instances the temperature of the internal structure may be in a range from 90 K to 140 K, 90 K to 130 K, 100 K to 125 K. In some examples the temperature of the internal structure may be substantially 100 K, or approximately 100 K. An advantage of this temperature range may be that it freezes out contaminants such as (less volatile) hydrocarbons and water. An advantage of using 100 K cooling temperature may be that hydrogen can still be a gas at this temperature. As a result this temperature may be applied in setups where hydrogen gas is used. Oxygen can still be a gas around 90 K, helium can remain in gas form until 4 K. 77 K may be interesting as the temperature because it is easy to achieve, through liquid nitrogen cooling. An example of introducing hydrogen gas may be in areas where a carbon deposit is present. Hydrogen gas may interact with the carbon form methane CH₄, which may be volatile, and as a result may be removed through vacuum pumps. Hydrogen gas may therefore reduce the carbon deposit amount.

During operation the vessel 802 may be held at a vacuum pressure of 0.05 mbar or less. In some instances, during operation the vessel may be held at a vacuum pressure of 0.01 mbar or less. An advantage of having a pressure of 0.05 mbar or less may be that the thermal insulation caused by the vacuum is good enough for the temperature of the internal structure 806 not to be conducted throughout the volume of the vessel 802. Thermal insulation of the cooled internal structure from its environment is important, for example to avoid damage to surrounding components and/or the vessel by the cold temperatures. The lower the pressure, the better the thermal insulation achieved by the vacuum. Another advantage of operating in a vacuum may be that it prevents light absorption.

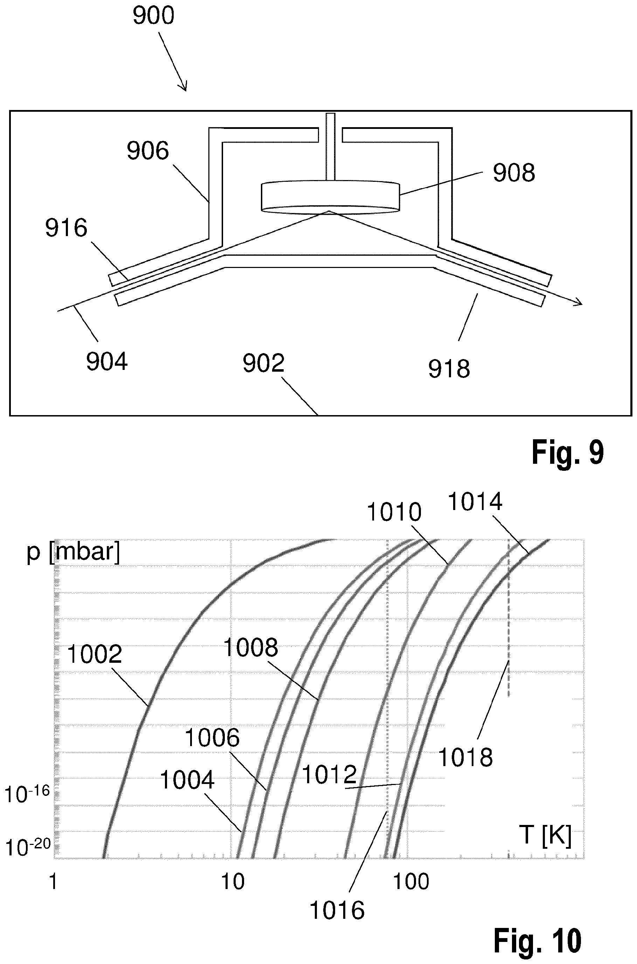

In some implementations, the internal structure may be targeted at one or more specific components of interest. Figure 9 depicts a graphic representation of an assembly 900 in which a component 908 to be protected, for example an optical component, is at least partially enclosed by an internal structure 906. The internal structure may be referred to as an enclosure 906. The enclosure 906 may comprise walls and an inner space formed by the walls surrounding the inner space of the enclosure 906. This may be an example of an assembly in which a purging gas flow is replaced by a cold enclosure around a component to be protected. The optical component 908 and enclosure 906 may be provided inside of vessel 902, for example as described in relation to Figure 8. The enclosure 906 may comprise an input end and an output end through which radiation can enter and exit the enclosure via the optical component 908. The cold enclosure 906 may act as a cryo-cooler, which may be referred to as a cold finger. A cryo-cooler may trap contaminants such as hydrocarbons and water on its surface to its low temperature. In some embodiments, the enclosure 906 may be a vessel which may optionally have the shape of a cask, bottle, kettle, cup, or bowl.

The input end 916 may comprise an elongated structure with a hollow core. The input end 916 may be oriented such that radiation incident onto optical component 908 may propagate through the hollow core of the elongated structure of input and 916. The output end 918 may comprise an elongated structure with a hollow core. The output end 918 may be oriented such that radiation reflected/diffracted/transmitted by the optical component 908 may propagate through the hollow core of the elongated structure of output end 918. The internal walls of the input end, and/or output end surrounding the hollow core may be cooled such that any contaminants trying to enter the inner space of the enclosure 906 via the input end or output end are absorbed onto the walls of the enclosure. An advantage of the elongate design of the input end/output end of the enclosure may therefore be the entrapment of contaminants trying to enter the inner space of the enclosure. As a result, the concentration of contaminants inside the inner space may be lower than the concentration of contaminants inside the vessel 902 as a whole. This results in the optical component 908 having increased protection from contaminant deposition. Contaminants present inside the inner space of the enclosure, may also be adsorbed by the internal wall surfaces of the enclosure. In some embodiments, the optical component 908 present inside the enclosure may be heated. Having the surface of the optical element may be heated to stimulate desorption of contaminants from the heated surface. The heated surface may for example be a reflective surface of a mirror. Heating the surface of the optical element may also prevent it from cooling down despite the presence of the cold environment/cold surfaces of the enclosure, which may avoid it turning into a cryo-surface itself.

More generally, the enclosure may have a geometry similar to a conventional flushbox, with narrow input and output channels forming an input end and an output end. Hydrocarbon or water contaminants that try to enter the flush box will stick to the walls due to the low temperature. This significantly reduces the probability of a contaminant entering the inner space of the enclosure through the narrow channel of the ends. The geometry requirements of the enclosure may be less strict than for conventional flushbox. Where a conventional flushbox needs to be a (near) leak tight structure, this requirement is not as strict for a cooling enclosure. Cold enclosure may cover only the line of sight of the sensitive surface of the optical component 908. Even if the enclosure is not leak tight, several interactions of a contaminant with the cold surface of the enclosure are likely before a contaminant could reach the optical component 908. Furthermore, any contaminants that do not stick to the cold surface of enclosure 906 may be sufficiently volatile for a vacuum pump to pump them out of the vessel 902.

An assembly with a cryo-cooled enclosure around an optical component may for example be used in a metrology apparatus or inspection apparatus. The metrology apparatus may for example use short wavelength radiation for measuring one or more parameters of a target substrate, such as a lithographically patterned target substrate. The pressure inside the metrology apparatus may be 0.05 mbar or less, such as for example 0.01 mbar or less. The temperature control system used for cooling the enclosure may for example be a liquid nitrogen cooling system.

Another example implementation in which contaminant removal may be of interest is in a lithographic, metrology, or inspection apparatus. The presence of contaminants must be sufficiently low during operation of a lithography tool to ensure correct operation. A first charge may be the presence of water. After venting of the system (which may open it to atmospheric pressure), the walls and components inside a lithography tool vessel may be covered with water. This water may be a risk to the components inside the vessel, for example due to oxidation. The water should be removed before switching on the radiation source, which may be for example an EUV/SXR radiation source. However pumping away water contaminants may be slow, and may take several hours, which is a significant downtime which reduces availability of the lithography tool to the user. It would be desirable to reduce the pumpdown time. Switching on the radiation source too early, before contaminants are removed, may be detrimental to the lifetime of the optical components, for example by degradation of the mirrors.

Proposed herein is an implementation in which a cryo-cooled internal structure is used to accelerate pumpdown. The contaminant removal on the cry-cooled surface may contribute to pressure reduction inside the vessel. This cryo-cooled pumpdown may be performed in parallel with a turbo-molecular vacuum pumping system. An advantage of turning on cryo-cooling during pumpdown may be that it would decrease the downtime, increase the availability of the tool. The cryo-cooled internal structure should not be turned on until the pressure inside the vessel is low enough to achieve thermal insulation. Thermal insulation may for example be achieved at a pressure of 0.05 mbar or below. This pressure level may be referred to in some instances as a pre-vacuum level. The cryo-cooled internal structure may for example be internal structure 806 as shown in figure 8, and features described in relation to assembly 800.

In an example implementation the internal structure 806 may form part of the vessel 802. The internal structure 806 may for example form part of an inner wall of the vessel 802. An advantage of this location of the internal structure 806 may be that it does not take up additional space inside the vessel. The vessel 802 may be crowded with components and free space required for the propagation path of the radiation, meaning that limited space is available for adding internal cooling structures. An internal structure forming part of an inner wall of the vessel may be flat or curved in shape. The connection between the cryo-cooled internal structure and the rest of the vessel should be made using materials with poor thermal conductivity, to avoid transferring the cooling function to other parts of the vessel.

While the introduction of a cryo-cooled internal structure may help speed up the pumpdown process, and aid the removal of water contaminants, its presence may have disadvantages. Water and other contaminants may be trapped on the surface of the internal structure, but they are not actually removed from the vessel. Radiation present in the apparatus during operation, or plasma effects, may lead to desorption, which can compromise quality of the vacuum during operation of the tool. The surface area available may be limited, and may not be located near the optical component(s) most of interest to be protected.

To address these concerns an internal structure 806 may be provided that is enclosed within the vessel 802, and that may be movable, such as retractable, in and out of the vessel 802. The movable internal structure may for example be configured to be inserted into an optical compartment of the vessel which may include portions inside the volume of the vessel reserved for a propagation path of the radiation during pumpdown of the vessel when the radiation beam is turned off. The movable internal structure may be configured to be retracted from the propagation path once in low pressure is reached and the contaminants have been removed, and before the radiation beam is turned on.

In some implementations, the movable internal structure may be moved after pumpdown to a different location inside the vessel. An advantage of placing the internal structure in the radiation path during pumpdown may be that the cryo-cooled surface is closer to an optical component to be protected from contaminants. An advantage of moving the cryo- cooled surface may be to increase the distance of the cryo-cooled structure to the radiation and/or a plasma created by the radiation. This may mitigate risk of desorption of contaminants during operation of the tool, which may be caused by the presence of the high energy radiation/plasma particles.

In some implementations, the movable internal structure may be moved after pumpdown to a location outside of the vessel. The location outside of the vessel may for example be a vacuum chamber separate to the vessel, e.g. adjacent to the vessel. The separate vacuum chamber may be fully closed off from the main vessel. This may facilitate full removal of the contaminants from the vessel before the radiation is turned on. This may eliminate risk of contaminant desorption during operation. The separate vacuum chamber may be opened independently from the vessel. As a result, the internal structure may be heated to release contaminants from the surface, which may be pumped away by the vacuum system of the separate chamber, without requiring downtime of the lithography tool.

Another advantage of providing a movable internal structure may be that a larger cryo-cooled surface area may be provided. This may increase the rate at which contaminants are trapped surface of the internal structure, and therefore increase the effectiveness of the pumpdown process. The movable internal structure may make use of the volume of the vessel reserved for the radiation.

An internal structure 806 that is present inside the vessel, but does not form part of the internal walls of the vessel may be provided. Compared to an internal structure that forms part of an internal wall of the vessel, both sides of a surface of a panel that is inserted into the vessel may be used for contaminant adsorption. Solutions may be considered to increase the effective surface area of the cry-cooled internal structure. For example, the internal structure may comprise a plurality of insertable rods. This may increase the amount of available surface on which contaminants can be trapped. The internal structure may comprise an extendable body for increasing the surface area of the internal structure during pumpdown. The extendable body may for example comprise bellows and/or folding surfaces. This may further increase the effective contaminant trapping area, while reducing the required volume for installation of the internal structure.

Another advantage of making the internal structural movable may be that if a cryo-cooled surface is operating for a long time, contaminants accumulate on the surface, and may need to be cleaned. While this cleaning could be performed during maintenance, this may lead to additional downtime. Therefore an alternative solution is to make the cryo-cooled internal surface retractable. The internal structure may for example be retractable while the apparatus is running. In some instances the internal structure may be retracted once pumpdown is completed, but before the radiation source is turned on.

The temperature control system 808 may comprise a motor for powering the cooling. The cooling load inside the vacuum chamber may be non-zero, even when high thermal insulation under high vacuum conditions is achieved. Radiative heat transfer may occur from the surfaces of the internal structure to the internal walls of the vessel and optical components inside the vessel. The walls and optical components may be around room temperature. There may be convective heat transfer, for example caused by gas flows present in the apparatus (e.g. a hydrogen gas flow).

The motor may for example be comprised in a refrigerator, and the motor may be connected to a liquid nitrogen tank. The motor for powering the cooling may be separated from the vessel by a mechanical decoupler. The mechanical decoupler may connect the cooling infrastructure outside of the vessel to the internal structure located inside the vessel without transferring the vibrations from the motor to the vessel. This means the mechanical decoupler may transfer the cooling effect to the inside of the vessel without connecting any of the vibrations associated with the motor to the inside of the vessel. The mechanical decoupler may be a heat exchanger, which may for example comprise one or more copper braids.

Other types of cooling link may be considered, such as for example cryo-circulation of e.g. liquid nitrogen. An advantage of this cryo-circulation may be fast switching between cool-down and heating up. Other types of cooling include a cryo-heat-exchanger, two-phase cooling (e.g. liquid nitrogen in equilibrium with gas-phase nitrogen N₂). A combination of two or more cooling systems may also be implemented.

In some example implementations, the temperature of a component protected from contaminants may be heated such that it is (slightly) raised relative to its surroundings. This may reduce the residence time of contaminants on the surface of the component. The added energy of the raised temperature may further enhance the release of contaminants such as hydrocarbons, thereby increasing the likelihood that unwanted contaminants are migrating away from the surface of the component to the cooled internal surface for capturing the contaminant.

In some example implementations the internal structure may comprise a texturized surface. The texturized surface may for example be achieved by adding nanoparticles, or a metal aerogel. Other ways to introduce texture may include adding grooves, roughening the material, and/or adding a porous surface coating. Having a texturized surface may increase the overall (cooled) surface area of the internal structure, and therefore increase the amount of space available for contaminants to be adsorbed and trapped.

A potential further advantage of the presence of a temperature-controlled internal structure inside the vessel, may be that it provides some extra cooling effect that may extract heat introduced by the radiation present in the vessel during operation.

Figure 10 depicts an example graph 1000 of vapour pressure p (in mbar) of different gases as a function of temperature T (in Kelvin). The graph may be based on the Clausius-Clapeyron relation. Line 1002 depicts hydrogen gas H₂, line 1004 depicts nitrogen gas N₂, line 1006 oxygen gas O₂, line 1008 methane CH₄, line 1010 carbon dioxide CO₂, line 1012 water H₂O, line 1014 dodecane C₁₂H₂₆, line 1016 liquid nitrogen, and line 1018 boiling water. The graph shows that the water equilibrium pressure will be well below 10⁻¹⁰ mbar for a cryogenic temperature of the enclosure of 100 K or below. At a temperature of or around 100 K, hydrogen gas Hz, nitrogen gas N₂, and methane CH₄ will not be pumped. Methane gas CH₄ may be beneficial in some applications. Due to its volatility, it may be more easily removed using turbo-molecular vacuum systems.

In some implementations a thermally controlled insulating element, such as for example a controlled insulating ring, may be added around the cryo-cooled surface of the internal structure. This may for example be a water flow of a controlled temperature or a compensating heating element, or a combination of both. The insulating element may be used to protect temperature-sensitive elements, such optical components inside the vessel, such that they are not affected by the cryogenic cooling surface. The component to be protected may for example be a mirror.

The internal structure may in some instances be coated with a material that captures tin Sn. This coating may for example comprise ruthenium.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:
1. An assembly comprising:
   a vessel configured to receive a radiation beam;
   an internal structure forming part of the vessel or enclosed within the vessel;
   a temperature control system configured to control a temperature of the internal structure to be in a range of 77 K to 140 K.
2. An assembly according to clause 1, wherein the vessel is configured to be at a pressure of 0.05 mbar or less during operation of the assembly, or 0.01 mbar or less.
3. An assembly according to any of the preceding clauses, wherein the temperature control system is configured to control the temperature of the internal structure to be in a range from 90 K - 140 K, optionally in a range from 90 K - 130 K, optionally in a range from 100 K - 125 K, and optionally substantially 100 K.
4. An assembly according to any of the preceding clauses, wherein the radiation beam comprises one or more wavelengths in a range of 1 nm - 20 nm, or 1 nm - 10 nm, or 10 nm - 20 nm, or 9 nm - 18 nm, or 13.5 nm.
5. An assembly according to any of the preceding clauses, wherein the internal structure is configured to capture contaminants on at least one surface of the internal structure.
6. An assembly according to clause 5, wherein the internal structure is configured to remove captured contaminants from the vessel.
7. An assembly according to any of clauses 5-6, wherein the contaminants comprise hydrocarbons.
8. An assembly according to any of clauses 5-7, wherein the contaminants comprise water.
9. An assembly according to any of the preceding clauses, further comprising an optical component inside the vessel.
10. An assembly according to clause 9, wherein the optical component comprises a reflective optical component, and wherein directing the radiation beam by the optical component comprises reflecting the radiation beam.
11. An assembly according to any of clauses 9 - 10, wherein the optical component is configured to direct radiation having one or more wavelengths in a range of 1 nm to 20 nm.
12. An assembly according to any of the preceding clauses, wherein the internal structure is configured to be cooled during a process of pumping down the pressure inside the vessel.
13. An assembly according to any of the preceding clauses, wherein the internal structure comprises a texturized surface.
14. An assembly according to clause 13, wherein the texturized surface comprises at least one of nanoparticles or a metal aerogel.
15. An assembly according to any of the preceding clauses, wherein the internal structure is enclosed within the vessel, and is moveable inside the vessel.
16. An assembly according to clause 15, wherein the internal structure is moveable in and out of the vessel.
17. An assembly according to any of clauses 15 - 16, wherein the movable internal structure is configured to be inserted in a propagation path of the radiation during pumping down of the vessel when the radiation beam is turned off, and is configured to be retracted from the propagation path before the radiation beam is turned on.
18. An assembly according to any of clauses 15 - 17, wherein the internal structure comprises a plurality of insertable rods.
19. An assembly according to any of clauses 15 - 17, wherein the internal structure comprises an extendable body for increasing the surface area of the internal structure.
20. An assembly according to any of clauses 1 - 14, wherein the internal structure forms part of the vessel, and forms part of an inner wall of the vessel.
21. An assembly according to any of clauses 15 - 20, wherein the temperature control system comprises a motor for powering a cooling, and wherein the motor is separated from the vessel by a mechanical decoupler.
22. An assembly according to clause 21, wherein the mechanical decoupler is a heat exchanger.
23. An assembly according to any of clauses 21 - 22, wherein the motor is configured to drive a compressor pump.
24. An assembly according to any of clauses 1 - 14, wherein the internal structure is an enclosure enclosing an inner space, the enclosure comprising:
   an input end configured to be positioned in a propagation path of a radiation beam such that the radiation beam is directed into the inner space of the enclosure; and
   an output end configured to be positioned in the propagation path of the radiation beam such that the radiation beam is directed out of the inner space of the enclosure.
25. An assembly according to clause 24, wherein the input end comprises an elongated structure comprising a hollow core arranged along the propagation path of the radiation beam such that the radiation beam propagates along the hollow core of the elongated structure.
26. An assembly according to any of clauses 24 - 25, wherein the output end comprises an elongated structure comprising a hollow core arranged along the propagation path of the radiation beam such that the radiation beam propagates along the hollow core of the elongated structure.
27. An assembly according to any of clauses 24 - 26, wherein the enclosure is configured to capture contaminants on at least one surface adjacent the inner space so as to remove them from the inner space.
28. An assembly according to any of clauses 24 - 27, wherein the temperature control system comprises a liquid nitrogen cooling system.
29. A metrology apparatus comprising an assembly according to any of clauses 1 - 28.
30. An inspection apparatus comprising an assembly according to any of clauses 1 - 28.
31. An exposure apparatus comprising an assembly according to any of clauses 1 - 28.
32. A lithographic apparatus comprising an assembly according to any of clauses 1 - 28.
33. A litho cell comprising an apparatus according to any of clauses 29 - 32.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. An assembly comprising:
a vessel configured to receive a radiation beam;
an internal structure forming part of the vessel or enclosed within the vessel;
a temperature control system configured to control a temperature of the internal structure to be in a range of 77 K to 140 K.

2. An assembly according to claim 1, wherein the vessel is configured to be at a pressure of 0.05 mbar or less during operation of the assembly, or 0.01 mbar or less.

3. An assembly according to any of the preceding claims, wherein the temperature control system is configured to control the temperature of the internal structure to be in a range from 90 K - 140 K, optionally in a range from 90 K - 130 K, optionally in a range from 100 K - 125 K, and optionally substantially 100 K.

4. An assembly according to any of the preceding claims, wherein the internal structure is configured to capture contaminants on at least one surface of the internal structure.

5. An assembly according to any of the preceding claims, further comprising an optical component inside the vessel, wherein optionally the optical component comprises a reflective optical component, and wherein optionally directing the radiation beam by the optical component comprises reflecting the radiation beam.

6. An assembly according to any of the preceding claims, wherein the internal structure is configured to be cooled during a process of pumping down the pressure inside the vessel.

7. An assembly according to any of the preceding claims, wherein the internal structure comprises a texturized surface.

8. An assembly according to any of the preceding claims, wherein the internal structure is enclosed within the vessel, and is moveable inside the vessel.

9. An assembly according to claim 8, wherein the internal structure is moveable in and out of the vessel.

10. An assembly according to any of claims 8-9, wherein the internal structure comprises an extendable body for increasing the surface area of the internal structure.

11. An assembly according to any of claims 1-7, wherein the internal structure forms part of the vessel, and forms part of an inner wall of the vessel.

12. An assembly according to any of claims 8 - 11, wherein the temperature control system comprises a motor for powering a cooling, and wherein the motor is separated from the vessel by a mechanical decoupler.

13. An assembly according to any of claims 1-7, wherein the internal structure is an enclosure enclosing an inner space, the enclosure comprising:
an input end configured to be positioned in a propagation path of a radiation beam such that the radiation beam is directed into the inner space of the enclosure; and
an output end configured to be positioned in the propagation path of the radiation beam such that the radiation beam is directed out of the inner space of the enclosure.

14. A metrology or inspection apparatus comprising an assembly according to any of claims 1 - 13.

15. A lithographic apparatus comprising an assembly according to any of claims 1 - 13.
